Europäisches Patentamt

(19) European Patent Office

Office européen des brevets

(11) Publication number: **0 058 560**
**B1**

(12) **EUROPEAN PATENT SPECIFICATION**

(45) Date of publication of patent specification: **27.12.84**

(21) Application number: **82300772.9**

(22) Date of filing: **16.02.82**

(51) Int. Cl.³: **H 01 J 37/34, C 23 C 15/00**

(54) **Sputtering apparatus.**

(30) Priority: **18.02.81 JP 21550/81**

(43) Date of publication of application:
**25.08.82 Bulletin 82/34**

(45) Publication of the grant of the patent:
**27.12.84 Bulletin 84/52**

(84) Designated Contracting States:
**DE GB NL**

(56) References cited:
**GB-A-1 284 781**
**GB-A-1 330 013**
**US-A-3 282 815**
**US-A-3 325 394**
**US-A-3 716 472**
**US-A-4 094 764**
**US-A-4 175 029**

(73) Proprietor: **Hitachi, Ltd.**
**5-1, Marunouchi 1-chome**
**Chiyoda-ku Tokyo 100 (JP)**

(72) Inventor: **Homma, Yoshio**
**2-32-D408, Koyasu-cho**
**Hachioji-shi Tokyo (JP)**
Inventor: **Tsunekawa, Sukeyoshi**
**2-32-D301, Koyasu-cho**
**Hachioji-shi Tokyo (JP)**
Inventor: **Morisaki, Hiroshi**
**2142, Kamikurata-cho Totsuka-ku**
**Yokohama-shi Kanagawa-ken (JP)**
Inventor: **Harada, Seiki**
**918-101, Yokokawa-cho**
**Hachioji-shi Tokyo (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

## Description

### Background of the Invention

The present invention relates to a sputtering apparatus for forming a thin film of a predetermined material on a substrate by the use of ions which are emitted by a discharge under a reduced pressure.

A sputtering apparatus according to the prior art has a cathode and a substrate electrode mounted in an evacuated chamber acting as a ground shield, and there is mounted on the cathode a target which is made of the material which is to be deposited on the substrate. The substrate on which a thin film of the target material is to be formed is placed on that electrode surface plate of the substrate electrode which is positioned to face the cathode. The substrate electrode is either earthed or connected through a power divider to a high-frequency power source. The latter enables one to employ the "bias sputtering method", which is suitable for forming a flat thin film on a substrate having rough surfaces. This bias sputtering method is disclosed in detail in Japanese Patent Laid-Open Publication No. 50-24079 and Japanese Patent Publication No. 51-22912, for example. However, since the sputtering in such sputtering apparatus is at a low deposition rate, a sputtering apparatus including a permanent magnet in the cathode has been used so as to enhance the deposition rate. Such cathodes having a permanent magnet therein are called "planar magnetron high rate cathodes", and an example is disclosed in detail in Japanese Patent Publication No. 53-19319. Both the cathode and the substrate electrode of the sputtering apparatus thus far described according to the prior art have been made of a non-magnetic material such as Al, Cu, stainless steel or an alloy containing Al, Cu or the like.

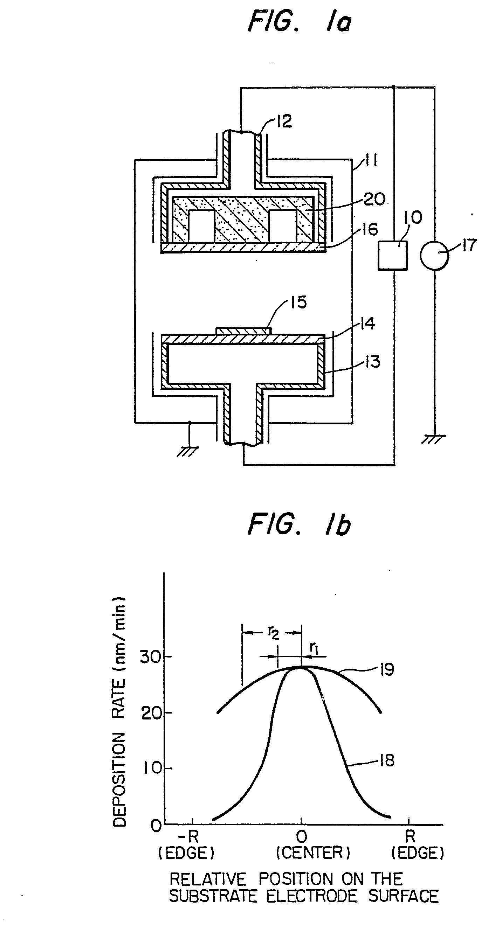

Fig. 1a is a schematic section showing one example of a sputtering apparatus. In an evacuated chamber 11 are mounted a cathode 12 and a substrate electrode 13. Inside the cathode 12 is disposed a permanent magnet 20. A substrate 15 made of Si, for example, and on which is to be formed a desired thin film, is placed on the electrode surface plate 14 (which is made of a non-magnetic material according to the prior art) of the substrate electrode 13. A target 16 is made of the material from which the thin film is to be formed, such as Al or $SiO_2$. The cathode 12 and the substrate electrode 13 are cooled with water, and the cathode 12 itself is connected to a high-frequency power source 17. On the other hand, the substrate electrode 13 is also connected through a power divider 10 to the high-frequency power source 17.

One example of the deposition rate distribution of the thin film material on the electrode surface plate 14 when the sputtering operation is carried out by the use of the sputtering apparatus thus far described is plotted as a curve 18 in Fig. 1b. According to this example, the ratio of the radius $r_1$ of a region (which will be referred to as a "uniform region") in which the distribution of the thickness of the film formed on the substrate 15 is withing ±10%, to the radius R of the electrode surface plate is 0.18 at most, so that the region in which the thickness of the thin film formed is substantially uniform is very limited. In other words, the usable size of the substrate 15 is undesirably limited to a considerable extent in to the prior art apparatus. Incidentally, more detailed description referring to Figs. 1a and 1b will be made in connection with the embodiments of the present invention.

### Summary of the Invention

According to the present invention, there is provided a sputtering apparatus comprising at least one cathode and at least one substrate electrode having an electrode surface plate which faces said cathode, characterised in that the electrode surface plate has at least a portion thereof made of a soft magnetic material.

Preferably the cathode is of the planar magnetron high rate type, since this gives good results when used in the bias sputtering method.

When the above-specified soft magnetic material has an initial permeability substantially lower than 100, the improvement in the uniformity of the deposition rate distribution may not be sufficient, so that the initial permeability shall preferably not be substantially less than 100. Examples of materials which can be used, as the above soft magnetic material include pure iron (containing 0.5 wt. % of an impurity at the highest), iron-silicon alloys, alperm, sendust, permalloy, super-permalloy, mumetal 45—25 perminver or ferroxcube.

Representative compositions of the respective soft magnetic materials enumerated above are: 1% Si — Fe for the iron-silicon alloys; 16% Al — Fe for the alperm; 9.5% Si — 5.5% Al — Fe for the sendust; 45% Ni — Fe or 80% Ni — Fe for the permalloy; 79% Ni — 5% No — 0.3% MN — Fe for the super-permalloy; 77% Ni — 2% Cr — 5% Cu — Fe for the mumetal; and 45% Ni — 25% Co — Fe for the perminver. Here, the respective percentages % are in weight, and the remainder is Fe. On the other hand, ferroxcube is a general name of cubic system ferrites.

It is desired that the thickness of the above-enumerated soft magnetic materials which form at least a portion of the aforementioned electrode surface plate be equal to or larger than 1 $\mu$m. If that thickness exceeds 1 $\mu$m, the resultant effects are little affected with the variation in the thickness. Although there is not especially an upper limit to the thickness of the soft magnetic material, there is a limit to the spacing between the cathode and the substrate electrode to be used in the sputtering apparatus. For practical purposes, therefore, the upper limit is set by that spacing. If the thickness is less

than 1 $\mu$m, it may become difficult to form a continuous film even by the use of the vacuum evaporation method or the like. In this case, the resultant effects of the present invention become deficient.

Although it is most desirable that the aforementioned electrode surface plate be made wholly of one of the above-enumerated soft magnetic materials, acceptable effects can be obtained even if the electrode surface plate has only a very limited portion made of the soft magnetic material. It is sufficient as a measure that the non-magnetic portion of the electrode surface plate in which the film formation rate is equal to or lower than one half of the maximum, be replaced by the soft-magnetic material. In order to attain substantially satisfactory effects, however, it is necessary that at least 20% of the aforementioned electrode surface plate be made of the soft magnetic material.

Moreover, the electrode surface plate may be prepared such that the surface of a non-magnetic material is covered with one of the soft magnetic materials or a non-magnetic material. As such non-magnetic material, there can be enumerated Cr, Al, Cu and stainless steel, for example.

Furthermore, a preferred sputtering apparatus, is constructed such that the aforementioned electrode surface plate has its center portion made of a material having a high heat conductivity such as Al and its peripheral portion made of a soft magnetic material. In the preferred embodiment, this maintains the substrate temperature during the sputtering operation at a temperature about 70°C lower than the conventional temperature of 320 to 350°C, if the substrate is placed on the above-specified center portion.

Brief Description of the Drawings

Fig. 1a is a schematic section illustrating a sputtering apparatus having a cathode of the planar magnetron high rate type;

Fig. 1b is a graphical presentation illustrating the deposition rate distributions of the prior art and one embodiment of the present invention;

Fig. 2a is a sectional view showing the construction in the vicinity of the substrate electrode of the sputtering apparatus according to another embodiment of the present invention; and

Fig. 2b is a graphical presentation illustrating the deposition rate distribution of the second embodiment of the present invention.

Description of the Preferred Embodiments

The present invention will be described in more detail in the following in conjunction with the embodiments and examples thereof.

Embodiment 1

A sputtering apparatus has the construction shown in Fig. 1a and its electrode surface plate 14 is made of pure iron (initially permeability: 200 to 300) containing 0.5 wt. % of impurity at the most. The permanent magnet 20 is constructed such that either an N or S pole is disposed at the center and is surrounded at a spacing of 3 to 6 cm by the opposite pole. The shape of that section of the central magnetic pole, which is arranged parallel to the target surface, is either a circle, usually with a diameter of 10 to 15 cm, or an oval or a rectangle usually with a shorter diameter or side of 10 to 15 cm. In the present embodiment, the target has a circular shape such that the N pole is surrounded at a spacing of 3.5 cm by the S pole, and has a diameter of 4 cm. The width of the annular S pole is 1 cm, and the diameter of the target is 15 cm. The material of the target 16 is $SiO_2$, and the substrate electrode 13 is made of Cu whereas the substrate 15 is made of Si. The electrode surface plate 14 is usually made to have a size substantially equal to or smaller than the target 16. In the present embodiment, both have the same size, having a diameter of 15 cm. The distance between the cathode 12 and the substrate electrode 13, i.e., the spacing between the target 16 and the electrode surface plate 14 is usually 3 to 6 cm and is 4.5 cm in the present embodiment. The rest of the construction and conditions are the same as has been described hereinbefore.

The substrate 15 is placed on the electrode surface plate 14 of the sputtering apparatus thus far described. After the chamber 11 has been evacuated, Ar under 0.8 Pa is introduced. The sputtering operations are effected by applying high-frequency electric powers of 2.5 W/cm² and 0.8 W/cm² to the cathode 12 and the substrate electrode 13, respectively.

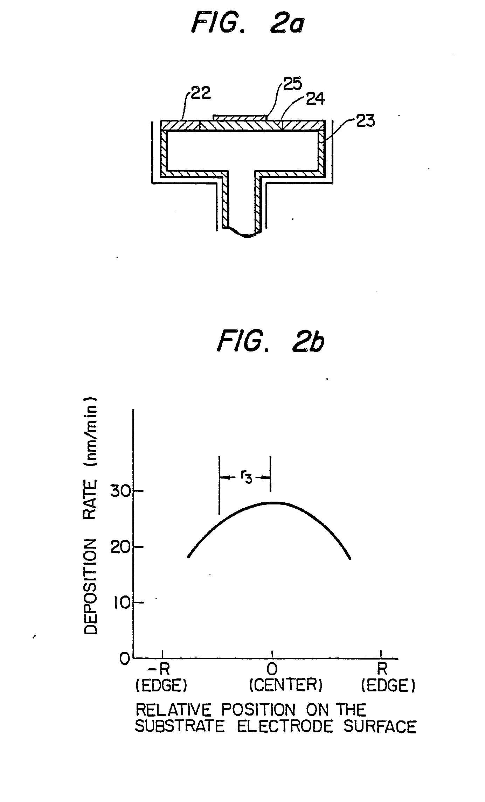

The measured results of the deposition rate distribution of the $SiO_2$ upon the electrode surface plate when the sputtering operation is performed under the above-specified conditions are plotted as a curve 19 in Fig. 1b. The ratio $r_2/R$ of the radius $r_2$ of the region (i.e., the uniform region), in which the thickness distribution of the $SiO_2$ film deposited is within a range of ±10%, to the radius R of the electrode surface plate 14 is about 0.5. As a result, the uniform region in the electrode surface plate 14 is about 7.7 times higher than the conventional value if the sputtering apparatus of the present embodiment is used. In Fig. 1b, and also in Fig. 2b appearing hereinafter, the abscissa indicates positions between the center O of the electrode surface plate of the substrate electrode and an edge R in terms of the relative distance from the center. The letter R indicates the radius of the electrode surface plate 14. On the other hand, the ordinate indicates the deposition rate (nm/mm) of the $SiO_2$.

Furthermore, the pure iron used as the electrode surface plate 14 may be conveniently prepared as usual by machining an iron plate having a thickness of 1 to several tens of millimetres, and is made to have a thickness of 10 mm in the present embodiment. Incidentally, it is sufficient, as has been described hereinbefore, that the thickness of the soft magnetic material is equal to or larger than 1 $\mu$m. When a very thin soft magnetic material is used, it is sufficient to form a film of the predetermined soft magnetic material on a non-magnetic material such as Al by the vacuum evaporation method to prepare the electrode surface plate. In this case, it has been difficult to form a continuous film for a thickness not exceeding 1 $\mu$m.

It is also sufficient to place the same material as that of the target upon the electrode surface plate 14 made of the soft magnetic material and to place thereon the substrate 15. In this case, since the soft magnetic material is not exposed to the plasma, the sample is not contaminated while the uniformity of the film forming rate is less deteriorated.

*Comparative Example 1*

The $SiO_2$ was deposited upon the substrate similarly to Embodiment 1 except that the electrode surface plate 14 was made of Al. The measured results of the deposition rate distribution of the $SiO_2$ on the electrode surface plate 14 are plotted as the curve 18 in Fig. 1$b$. The ratio $r_1/R$ of the radius $r_1$ of the uniform region to the radius R of the electrode surface 14 takes a value of about 0.18, as has been described hereinbefore, so that the uniform region is far narrower than that of the case of the foregoing embodiment, as will be understood.

*Embodiment 2*

Fig. 2$a$ is a sectional view showing the construction in the vicinity of the substrate electrode of the sputtering apparatus used in the present embodiment. Numeral 22 indicates the peripheral portion of the electrode surface plate, which is made of pure iron (heat conductivity: about 0.5 to 0.8 J/cm.s.K.) like that of Embodiment 1. Numeral 24 indicates the center portion (diameter 15 cm) of the electrode surface plate and is made of Al having a heat conductivity of about 2.3 J/cm.s.K. Numeral 23 indicates the substrate electrode. A substrate 25 made of Si and was placed on the center portion 24, thereby to improve the thermal contact between the substrate 25 and the substrate electrode 23. The $SiO_2$ deposited upon the substrate similarly to Embodiment 1, excepting the aforementioned items.

In the present embodiment, the substrate temperature in the deposition of the $SiO_2$ film was 250 to 280°C so that it could be maintained about 70°C lower than that of Embodiment 1.

On the other hand, the measured results of the deposition rate distribution of the $SiO_2$ on the electrode surface plate of the substrate electrode are plotted in Fig. 2$b$. The ratio $r_3/R$ of the radius $r_3$ of the uniform region to the radius R of the electrode surface plate takes a value of about 0.47, and the deposition rate distribution is accepted as sufficiently practical and substantially satisfactory, although slightly less than that of Embodiment 1. As a result, an $SiO_2$ film having an excellent thickness distribution could be deposited at a relatively low substrate temperature with the present embodiment. By depositing the $SiO_2$ film in the manner according to the present embodiment, the substrate 25 is less liable to be damaged during the formation of the $SiO_2$ film.

As has been described hereinbefore, the uniformity in the thickness distribution of the film deposited is markedly improved by the use of the preferred sputtering methods of the present invention.

When the sputtering apparatus described above is used to deposit thin films on a substrate, the uniformity of the deposition rate distribution is greatly improved, giving a thin film having an excellently uniform thickness.

Moreover, the sputtering apparatus of the present invention can also be applied to processes for forming many kinds of metal films such as Al, Ti, Cr and so on and also to insulating films of silicon nitride, $AL_2O_3$ and so on.

Although all the embodiments thus far described are directed to the case in which pure iron was used as the soft magnetic material, it has been found that the uniformity of the deposition rate distribution is better improved if permalloy, super-permalloy, mumetal and so on are used. However, these magnetic materials are far more expensive than pure iron.

Obviously, many modifications and variations of the present invention are possible in the light of the above teachings. For example the sputtering apparatus described may have its construction modified such that the cathode 12 and the substrate electrode 13 are coaxially placed to face each other although the cathode 12 and the substrate electrode 13 are usually juxtaposed to face each other, as shown in Fig. 1$a$.

**Claims**

1. A sputtering apparatus comprising at least one cathode (12) and at least one substrate electrode (13) having an electrode surface plate (14; 22, 24) which faces said cathode, characterised in that the electrode surface plate has at least a portion (14; 22) thereof made of a soft magnetic material.

2. A sputtering apparatus as set forth in claim 1, wherein the soft magnetic material has an initial permeability not substantially less than 100.

3. A sputtering apparatus as set forth in claim 1 or claim 2, wherein said cathode (12) is a planar magnetron high rate type cathode.

4. A sputtering apparatus as set forth in any one of the preceding claims, wherein said electrode surface plate has at least 20% of its area (22) made of said soft magnetic material.

5. A sputtering apparatus as set forth in any one of claims 1 to 3, wherein said electrode surface plate has its whole area (14) made of said soft magnetic material.

6. A sputtering apparatus as set forth in any one of the preceding claims, wherein at least the portion of said electrode surface plate made of said soft magnetic material has its surface covered with a non-magnetic material.

7. A sputtering apparatus as set forth in any one of the preceding claims, wherein said electrode surface plate has at least a portion made of a non-magnetic material which has its surface covered with said soft magnetic material.

8. A sputtering apparatus as set forth in any one of the preceding claims, wherein said electrode surface plate has its center portion (24) made of a material having a relatively high heat conductivity and its peripheral portion (22) made of said soft magnetic material.

9. A sputtering apparatus as set forth in any of the preceding claims, wherein said substrate electrode (13) is connected through a power divider (10) to a high-frequency power source (17).

**Patentansprüche**

1. Zerstäubungsvorrichtung mit mindestens einer Kathode (12) und mindestens einer Substratelektrode (13), die eine der Kathode zugewandte Elektroden-Oberflächenplatte (14; 22, 24) aufweist, dadurch gekennzeichnet, daß die Elektroden-Oberflächenplatte mindestens einen aus einem weichmagnetischen Material bestehenden Teil (14; 22) aufweist.

2. Zerstäubungsvorrichtung nach Anspruch 1, wobei das weichmagnetische Material eine Anfangspermeabilität von nicht wesentlich kleiner als 100 aufweist.

3. Zerstäubungsvorrichtung nach Anspruch 1 oder 2, wobei die Kathode (12) eine Planar-Magnetron-Hochgeschwindigkeits-Kathode ist.

4. Zerstäubungsvorrichtung nach einem verhergehenden Ansprüche, wobei mindestens 20% der Fläche (22) der Elektroden-Oberflächenplatte aus dem weichmagnetischen Material besteht.

5. Zerstäubungsvorrichtung nach einem der Ansprüche 1 bis 3, wobei die gesamte Fläche (14) der Elektroden-Oberflächenplatte aus dem weichmagnetischen Material besteht.

6. Zerstäubungsvorrichtung nach einem der vorhergehenden Ansprüche, wobei die Oberfläche mindestens des aus dem weichmagnetischen Material bestehenden Teils der Elektroden-Oberflächenplatte mit einem nicht-magnetischen Material bedeckt ist.

7. Zerstäubungsvorrichtung nach einem der vorhergehenden Ansprüche, wobei mindestens ein Teil der Elektroden-Oberflächenplatte aus einem nicht-magnetischen Material besteht, dessen Oberfläche mit dem weichmagnetischen Material bedeckt ist.

8. Zerstäubungsvorrichtung nach einem der vorhergehenden Ansprüche, wobei der Mittelteil (24) der Elektroden-Oberflächenplatte aus einem Material mit verhältnismäßig hoher Wärmeleitfähigkeit und ihr Randteil (22) aus dem weichmagnetischen Material besteht.

9. Zerstäubungsvorrichtung nach einem der vorhergehenden Ansprüche, wobei die Substratelektrode (13) über einen Energieteiler (10) an eine Hochfrequenz-Energiequelle (17) angeschlossen ist.

**Revendications**

1. Dispositif de pulvérisation comprenant au moins une cathode (12) et au moins une électrode de substrate (13) ayant une plaque de surface d'électrode (14; 22, 24) qui fait face à ladite cathode, caractérisé en ce que la plaque de surface d'électrode a au moins une partie (14; 22) faite en une matière magnétique douce.

2. Dispositif de pulvérisation selon la revendication 1 où la matière magnétique douce a une perméabilité initiale qui n'est pas sensiblement inférieure à 100.

3. Dispositif de pulvérisation selon la revendication 1 ou la revendication 2 où ladite cathode (12) est une cathode plane du type magnétron haute fréquence.

4. Dispositif de pulvérisation selon l'une quelconque des revendications précédentes où ladite plaque de surface d'électrode a au moins 20% de sa surface (22) formée de ladite matière magnétique douce.

5. Dispositif de pulvérisation selon l'une quelconque des revendications 1 à 3, où ladite plaque de surface d'électrode a la totalité de sa surface (14) faite de ladite matière magnétique douce.

6. Dispositif de pulvérisation selon l'une quelconque des revendications précédentes où au moins la partie de ladite plaque de surface d'électrode faite de la matière magnétique douce à surface couverte d'une matière non-magnétique.

7. Dispositif de pulvérisation selon l'une quelconque des revendications précédentes où ladite plaque de surface d'électrode a au moins une partie faite d'une matière non-magnétique dont la surface est couverte de ladite matière magnétique douce.

8. Dispositif de pulvérisation selon l'une quelconque des revendications précédentes où ladite plaque de surface d'électrode a sa partie centrale (24) faite d'une matière ayant une conductivité thermique relativement élevée et sa partie périphérique (22) faite de ladite matière magnétique douce.

9. Dispositif de pulvérisation selon l'une quelconque des revendications précédentes où ladite électrode formant substrat (13) est connectée par un diviseur du puissance (10) à une source de puissance haute-fréquence (17).

## FIG. 1a

## FIG. 1b

RELATIVE POSITION ON THE
SUBSTRATE ELECTRODE SURFACE

1

0 058 560

# FIG. 2a

# FIG. 2b

DEPOSITION RATE (nm/min)

$r_3$

-R (EDGE)     O (CENTER)     R (EDGE)

RELATIVE POSITION ON THE
SUBSTRATE ELECTRODE SURFACE